# EUROPEAN PATENT APPLICATION

(11) **EP 4 135 025 A1**
(43) Date of publication of application: **15.02.2023**
(21) Application number: 21784136.0
(22) Date of filing: 02.04.2021
(51) Int. Cl.: H01L 23/48, H01L 23/495, H01L 23/498, H01L 25/16, H01L 27/15

(54) **TERMINAL CONNECTION STRUCTURE, DISPLAY UNIT, AND DISPLAY**

(30) Priority: 08.04.2020 CN 202010270049
(71) Applicant: Beijing Ivisual 3D Technology Co., Ltd., Beijing 100055 (CN); Visiotech Ventures Pte. Ltd., Singapore 188979 (SG)
(72) Inventor: DIAO, Honghao, Beijing 100055 (CN); HUANG, Lingxi, Singapore 188979 (SG)
(74) Representative: Manitz Finsterwald Patent- und Rechtsanwaltspartnerschaft mbB
(86) International application number: PCT/CN2021/085192
(87) International publication number: WO 2021/204069

(57) **Abstract**

The present application relates to the technical field of optics, and discloses a terminal connection structure, including: a plurality of terminals, a plurality of terminal-side conductive holes, an electrical connection layer, and a plurality of light emitting device-side conductive holes, where the electrical connection layer is capable of being electrically connected with a plurality of light emitting devices through a plurality of light emitting device-side conductive holes, and electrically connected with a plurality of terminals through a plurality of terminal-side conductive holes; and a plurality of terminals are arranged in array. The terminal connection structure is adopted so that terminals for leading wires from light emitting devices may be effectively arranged even if a size of the light emitting devices is very small. The present application further discloses a display unit and a display.

## Description

The present application claims priority to the Chinese Patent Application with an application number of 202010270049.4 and a title of *"Terminal Connection Structure, Display Unit and Display",* filed to China National Intellectual Property Administration on April, 8th, 2020, the disclosures of which are hereby incorporated by reference.

### TECHNICAL FIELD

The present application relates to the technical field of optics, and for example, relates to a terminal connection structure, a display unit and a display.

### BACKGROUND

To control a light emitting device, a terminal for leading a wire from the light emitting device needs to be provided.

In a process of implementing embodiments of the present disclosure, at least the following problems are found in related technologies:
there is no technical solution to arrange terminals for leading wires from light emitting devices when a size of the light emitting devices is very small.

### SUMMARY

In order to provide a basic understanding of some aspects of the disclosed embodiments, a brief summary is given below. The summary is not intended to be a general comment, nor to identify key/important components or describe the scope of protection of the embodiments, but to be a preface to the following detailed description.

Embodiments of the present disclosure provide a terminal connection structure, a display unit and a display, to solve a technical problem that there is no technical solution to arrange terminals for leading wires from light emitting devices.

The terminal connection structure provided by embodiments of the present disclosure includes a plurality of terminals, a plurality of terminal-side conductive holes, an electrical connection layer, and a plurality of light emitting device-side conductive holes; where
the electrical connection layer is capable of being electrically connected with a plurality of light emitting devices through the plurality of light emitting device-side conductive holes, and electrically connected with the plurality of terminals through the plurality of terminal-side conductive holes; and
the plurality of terminals are arranged in array.

In some embodiments, the electrical connection layer may include at least two electrical connection layers; and the at least two electrical connection layers are capable of being electrically connected with a plurality of light emitting devices through the plurality of light emitting device-side conductive holes, and electrically connected with the plurality of terminals through the plurality of terminal-side conductive holes.

In some embodiments, the at least two electrical connection layers may include a light emitting device-side electrical connection layer and a terminal-side electrical connection layer; the plurality of light emitting device-side conductive holes may include a plurality of first light emitting device conductive holes and second light emitting device conductive holes;
where the light emitting device-side electrical connection layer is capable of being electrically connected with the plurality of light emitting devices through the plurality of first light emitting device conductive holes; and
the terminal-side electrical connection layer is capable of being electrically connected with the plurality of light emitting devices through the plurality of second light emitting device conductive holes.

In some embodiments, at least one of the plurality of light emitting devices may include a first electrode and a second electrode;
where the light emitting device-side electrical connection layer is capable of being electrically connected with the first electrode through at least one of the plurality of first light emitting device conductive holes; and
the terminal-side electrical connection layer is capable of being electrically connected with the second electrode through at least one of the plurality of second light emitting device conductive holes.

In some embodiments, each light emitting device of the plurality of light emitting devices may include a first electrode and a second electrode;
where the light emitting device-side electrical connection layer is capable of being electrically connected with first electrodes of different light emitting devices in the plurality of light emitting devices through the plurality of first light emitting device conductive holes respectively; and
the terminal-side electrical connection layer is capable of being electrically connected with second electrodes of different light emitting devices in the plurality of light emitting devices through the plurality of second light emitting device conductive holes respectively.

In some embodiments, the terminal-side electrical connection layer and the light emitting device-side electrical connection layer may be sequentially arranged from the plurality of terminals to the plurality of light emitting devices.

In some embodiments, at least one of the following insulation layers may further be included:
an insulation layer for isolating the plurality of terminals from the terminal-side electrical connection layer;
an insulation layer for isolating the terminal-side electrical connection layer from the light emitting device-side electrical connection layer; and
an insulation layer for isolating the light emitting device-side electrical connection layer from the plurality of light emitting devices.

In some embodiments, the plurality of terminal-side conductive holes may include a plurality of first terminal conductive holes and a plurality of second terminal conductive holes;
where the light emitting device-side electrical connection layer may be electrically connected with the plurality of terminals through the plurality of first terminal conductive holes;
the terminal-side electrical connection layer may be electrically connected with the plurality of terminals through the plurality of second terminal conductive holes.

In some embodiments, the plurality of terminals may include at least one first terminal and at least one second terminal;
where the light emitting device-side electrical connection layer may be electrically connected with the at least one first terminal through at least one of the plurality of first terminal conductive holes; and
the terminal-side electrical connection layer may be electrically connected with the at least one second terminal through at least one of the plurality of second terminal conductive holes.

In some embodiments, at least one first terminal may include a plurality of first terminals, and at least one second terminal may include a plurality of second terminals;
where the light emitting device-side electrical connection layer may be electrically connected with the plurality of first terminals through the plurality of first terminal conductive holes respectively; and
the terminal-side electrical connection layer may be electrically connected with the plurality of second terminals through the plurality of second terminal conductive holes respectively.

In some embodiments, at least one of the light emitting device-side electrical connection layer and the terminal-side electrical connection layer may be arranged in the following modes:
the light emitting device-side electrical connection layer includes at least one layer of light emitting device-side conductive lines; and
the terminal-side electrical connection layer includes at least one layer of terminal-side conductive lines.

In some embodiments, at least one of the light emitting device-side conductive lines and the terminal-side conductive lines may be arranged in array.

In some embodiments, at least one of the light emitting device-side conductive lines and the terminal-side conductive lines may be arranged in array in a form of rows or columns.

In some embodiments,
the light emitting device-side conductive lines may be arranged in array in a form of rows, and the terminal-side conductive lines may be arranged in array in a form of columns; or,
the light emitting device-side conductive lines may be arranged in array in a form of columns, and the terminal-side conductive lines may be arranged in array in a form of rows.

In some embodiments, each line of the terminal-side conductive lines may be electrically connected with at least one terminal of the plurality of terminals.

In some embodiments, at least one terminal of the plurality of terminals may cover at least one terminal-side conductive hole of the plurality of terminal-side conductive holes.

In some embodiments, part or all of the plurality of terminals may be arranged at equal intervals.

In some embodiments,
part of the plurality of terminals may be arranged in array; or,
all of the plurality of terminals may be arranged in array.

The display unit provided by embodiments of the present disclosure includes a plurality of light emitting devices and the above terminal connection structure.

In some embodiments, the plurality of light emitting devices may include at least one light emitting diode (LED) light emitting device.

In some embodiments, at least one LED light emitting device may include at least one Micro LED light emitting device.

In some embodiments, the plurality of light emitting devices may be arranged in array.

In some embodiments,
part of the plurality of light emitting devices may be arranged in array; or,
all of the plurality of light emitting devices may be arranged in array.

The display provided by embodiments of the present disclosure includes the above display unit.

The terminal connection structure, the display unit and the display provided by embodiments of the present disclosure may achieve the following technical effects:
terminals for leading wires from light emitting devices may be arranged effectively even if a size of the light emitting devices is very small.

The above general description and the following description are exemplary and explanatory only, and are not intended to limit the present application.

### DESCRIPTION OF DRAWINGS

One or more embodiments are illustrated by the corresponding drawings, and the illustrations and drawings do not limit the embodiments. Elements having the same reference numerals in the drawings are shown as similar elements, and the drawings are not intended to limit the scale, where:
Figs. 1A and 1B are structural schematic diagrams of a terminal connection structure provided by embodiments of the present disclosure;
Fig. 2 is another structural schematic diagram of the terminal connection structure provided by embodiments of the present disclosure;
Fig. 3 is another structural schematic diagram of the terminal connection structure provided by embodiments of the present disclosure;
Fig. 4 is another structural schematic diagram of the terminal connection structure provided by embodiments of the present disclosure;
Fig. 5 is another structural schematic diagram of the terminal connection structure provided by embodiments of the present disclosure;
Fig. 6 is another structural schematic diagram of the terminal connection structure provided by embodiments of the present disclosure;
Fig. 7 is another structural schematic diagram of the terminal connection structure provided by embodiments of the present disclosure;
Fig. 8 is another structural schematic diagram of the terminal connection structure provided by embodiments of the present disclosure;
Figs. 9A and 9B are structural schematic diagrams of a light emitting device-side electrical connection layer and a terminal-side electrical connection layer provided by embodiments of the present disclosure;
Figs. 10A, 10B, 10C and 10D are schematic diagrams of arrangements of light emitting device-side conductive lines and terminal-side conductive lines provided by embodiments of the present disclosure;
Fig. 11 is a structural schematic diagram of a display unit provided by embodiments of the present disclosure;
Fig. 12 is another structural schematic diagram of the display unit provided by embodiments of the present disclosure;
Fig. 13 is another structural schematic diagram of the display unit provided by embodiments of the present disclosure;
Fig. 14 is another structural schematic diagram of the display unit provided by embodiments of the present disclosure; and
Figs. 15A and 15B are structural schematic diagrams of a display provided by embodiments of the present disclosure.

### Reference numerals:

110: terminal; 111: first terminal; 112: second terminal; 120: terminal-side conductive hole; 121: first terminal conductive hole; 122: second terminal conductive hole; 130: electrical connection layer; 131: light emitting device-side electrical connection layer; 1311: light emitting device-side conductive line; 132: terminal-side electrical connection layer; 1321: terminal-side conductive line; 140: light emitting device-side conductive hole; 141: first light emitting device conductive hole; 142: second light emitting device conductive hole; 150: light emitting device; 151: first electrode; 152: second electrode; 153: LED light emitting device; 154: Micro LED light emitting device; 160: insulation layer; 170: insulation layer; 180: insulation layer; 200: display unit; and 300: display.

### DETAILED DESCRIPTION

To understand features and technical contents of embodiments of the present disclosure in more detail, implementation of the embodiments of the present disclosure is described in detail below with reference to accompanying drawings; and the accompanying drawings are used for reference only, rather than limiting the embodiments of the present disclosure. In following technical description, for the convenience of explanation, a thorough understanding of the disclosed embodiments is provided through more details. However, one or more embodiments may be implemented without the details. In other cases, to simplify the accompanying drawings, well-known structures and apparatuses may be shown simplistically.

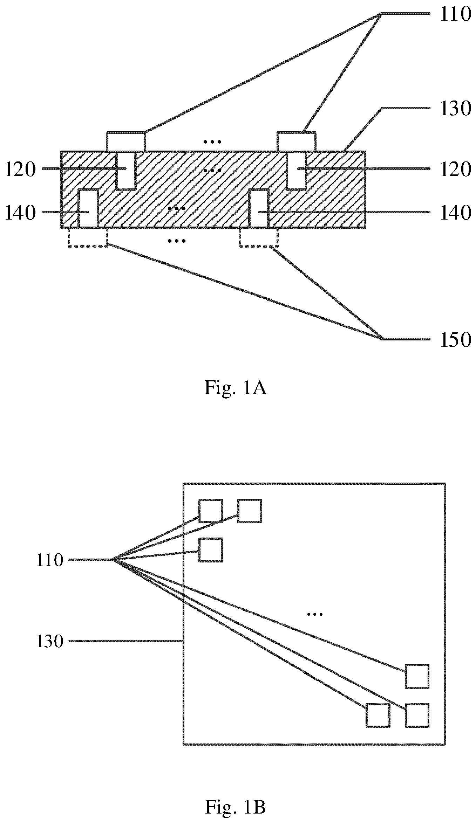

Referring to Figs. 1A and 1B, embodiments of the present disclosure provide a terminal connection structure, including a plurality of terminals 110, a plurality of terminal-side conductive holes 120, an electrical connection layer 130, and a plurality of light emitting device-side conductive holes 140; where
the electrical connection layer 130 is capable of being electrically connected with a plurality of light emitting devices 150 through the plurality of light emitting device-side conductive holes 140, and electrically connected with a plurality of terminals 110 through the plurality of terminal-side conductive holes 120; and
the plurality of terminals 110 are arranged in array.

In some embodiments, the electrical connection layer 130 may include at least two electrical connection layers; and the at least two electrical connection layers are capable of being electrically connected with the plurality of light emitting devices 150 through the plurality of light emitting device-side conductive holes 140, and electrically connected with the plurality of terminals 110 through the plurality of terminal-side conductive holes 120.

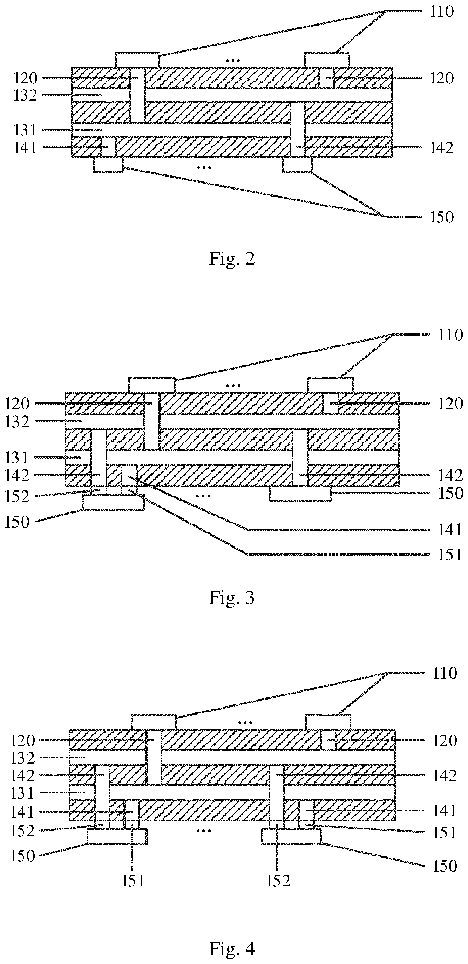

Referring to Fig. 2, in some embodiments, the at least two electrical connection layers may include a light emitting device-side electrical connection layer 131 and a terminal-side electrical connection layer 132. Optionally, the plurality of light emitting device-side conductive holes 140 may include a plurality of first light emitting device conductive holes 141 and second light emitting device conductive holes 142.

In some embodiments, the light emitting device-side electrical connection layer 131 is capable of being electrically connected with the plurality of light emitting devices 150 through the plurality of first light emitting device conductive holes 141; and the terminal-side electrical connection layer 132 is capable of being electrically connected with the plurality of light emitting devices 150 through the plurality of second light emitting device conductive holes 142.

Referring to Fig. 3, in some embodiments, at least one of the plurality of light emitting devices 150 may include a first electrode 151 and a second electrode 152.

In some embodiments, the light emitting device-side electrical connection layer 131 is capable of being electrically connected with the first electrode 151 through at least one of the plurality of first light emitting device conductive holes 141; and the terminal-side electrical connection layer 132 is capable of being electrically connected with the second electrode 152 through at least one of the plurality of second light emitting device conductive holes 142.

Referring to Fig. 4, in some embodiments, each light emitting device 150 of the plurality of light emitting devices 150 may include a first electrode 151 and a second electrode 152.

In some embodiments, the light emitting device-side electrical connection layer 131 is capable of being electrically connected with first electrodes 151 of different light emitting devices 150 of the plurality of light emitting devices 150 through the plurality of first light emitting device conductive holes 141 respectively; and the terminal-side electrical connection layer 132 is capable of being electrically connected with second electrodes 152 of different light emitting devices 150 of the plurality of light emitting devices 150 through the plurality of second light emitting device conductive holes 142 respectively.

In some embodiments, the terminal-side electrical connection layer 132 and the light emitting device-side electrical connection layer 131 may be sequentially arranged from the plurality of terminals 110 to the plurality of light emitting devices 150.

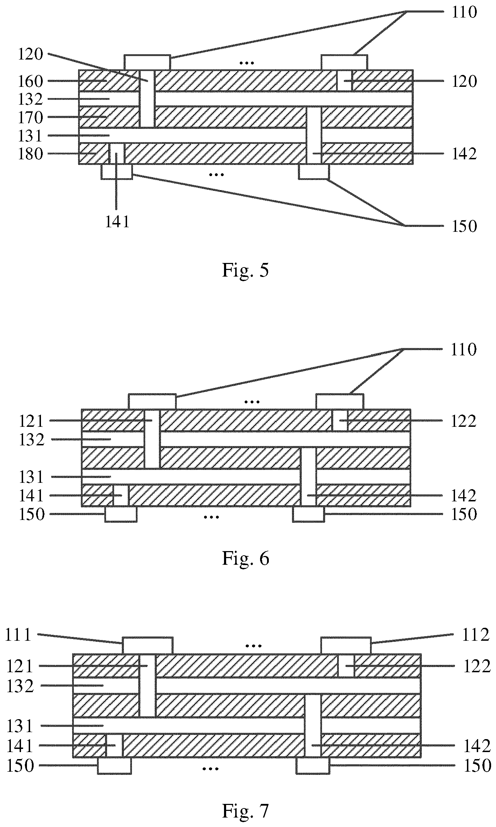

Referring to Fig. 5, in some embodiments, the terminal connection structure may further include at least one of the following insulation layers:
an insulation layer 160 for isolating the plurality of terminals 110 from the terminal-side electrical connection layer 132;
an insulation layer 170 for isolating the terminal-side electrical connection layer 132 from the light emitting device-side electrical connection layer 131; and
an insulation layer 180 for isolating the light emitting device-side electrical connection layer 131 from the plurality of light emitting devices 150.

In some embodiments, at least one of the insulation layer 160, the insulation layer 170 and the insulation layer 180 may include at least one layer of insulation structure.

Referring to Fig. 6, in some embodiments, the plurality of terminal-side conductive holes 120 may include a plurality of first terminal conductive holes 121 and a plurality of second terminal conductive holes 122.

In some embodiments, the light emitting device-side electrical connection layer 131 may be electrically connected with the plurality of terminals 110 through the plurality of first terminal conductive holes 121; and the terminal-side electrical connection layer 132 may be electrically connected with the plurality of terminals 110 through the plurality of second terminal conductive holes 122.

Referring to Fig. 7, in some embodiments, the plurality of terminals 110 may include at least one first terminal 111 and at least one second terminal 112.

In some embodiments, the light emitting device-side electrical connection layer 131 may be electrically connected with the at least one first terminal 111 through at least one of the plurality of first terminal conductive holes 121; and the terminal-side electrical connection layer 132 may be electrically connected with the at least one second terminal 112 through at least one of the plurality of second terminal conductive holes 122.

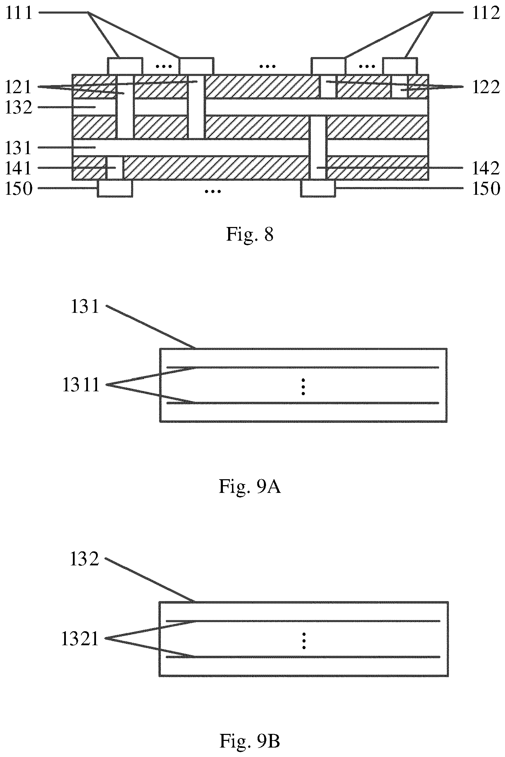

Referring to Fig. 8, in some embodiments, the at least one first terminal 111 may include a plurality of first terminals 111; and at least one second terminal 112 may include a plurality of second terminals 112.

In some embodiments, the light emitting device-side electrical connection layer 131 may be electrically connected with the plurality of first terminals 111 through the plurality of first terminal conductive holes 121 respectively; and the terminal-side electrical connection layer 132 may be electrically connected with the plurality of second terminals 112 through the plurality of second terminal conductive holes 122 respectively.

Referring to Figs. 9A and 9B, in some embodiments, at least one of the light emitting device-side electrical connection layer 131 and the terminal-side electrical connection layer 132 may be arranged in the following modes:
the light emitting device-side electrical connection layer 131 includes at least one layer of light emitting device-side conductive lines 1311; and
the terminal-side electrical connection layer 132 includes at least one layer of terminal-side conductive lines 1321.

In Fig. 9A, the light emitting device-side conductive lines 1311 of different layers are exemplified from top to bottom in the light emitting device-side electrical connection layer 131. Optionally, each wire segment in the light emitting device-side electrical connection layer 131 represents a layer of light emitting device-side conductive lines 1311.

In Fig. 9B, the terminal-side conductive lines 1321 of different layers are exemplified from top to bottom in the terminal-side electrical connection layer 132. Optionally, each wire segment in the terminal-side electrical connection layer 132 represents a layer of terminal-side conductive lines 1321.

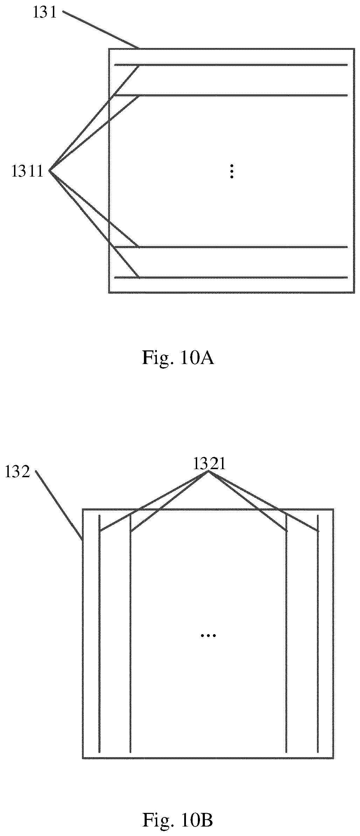

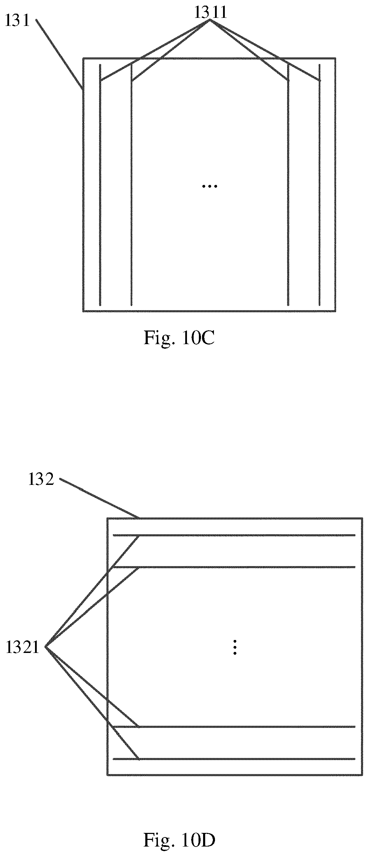

Referring to Figs. 10A, 10B, 10C and 10D, in some embodiments, at least one of the light emitting device-side conductive lines 1311 and the terminal-side conductive lines 1321 may be arranged in array.

In some embodiments, at least one of the light emitting device-side conductive lines 1311 and the terminal-side conductive lines 1321 may be arranged in array in a form of rows or columns.

As shown in Figs. 10A and 10B, in some embodiments, the light emitting device-side conductive lines 1311 may be arranged in array in a form of rows; and the terminal-side conductive lines 1321 may be arranged in array in a form of columns. As shown in Figs. 10C and 10D, in some embodiments, the light emitting device-side conductive lines 1311 may be arranged in array in a form of columns; and the terminal-side conductive lines 1321 may be arranged in array in a form of rows.

As shown in Figs. 10A, 10B, 10C and 10D, an array arrangement mode of the light emitting device-side conductive lines 1311 and the terminal-side conductive lines 1321 may be a row-and-column mode. In some embodiments, the array arrangement mode of the light emitting device-side conductive lines 1311 and the terminal-side conductive lines 1321 may be different from that shown in Fig. 1B, but may be arrangement modes in other array shapes, such as circular, elliptical, triangular and other array arrangement modes. Optionally, the array arrangement mode of the light emitting device-side conductive lines 1311 and the terminal-side conductive lines 1321 is insignificant, as long as a plurality of terminals 110 for leading wires from the light emitting devices 150 may be effectively arranged.

In some embodiments, each line of the terminal-side conductive lines 1321 may be electrically connected with at least one terminal 110 of the plurality of terminals 110. Optionally, each line of the light emitting device-side conductive lines 1311 may be electrically connected with at least one terminal 110 of the plurality of terminals 110.

In some embodiments, each line of the terminal-side conductive lines 1321 may be electrically connected with one second terminal 112 of the plurality of second terminals 112, so that different lines of the terminal-side conductive lines 1321 are electrically connected with different second terminals 112 of the plurality of second terminals 112 respectively. Optionally, each line of the terminal-side conductive lines 1321 may be electrically connected with at least two second terminals 112 of the plurality of second terminals 112, to provide a backup of electrical connection between the second terminals 112 and the terminal-side conductive lines 1321.

In some embodiments, each line of the light emitting device-side conductive lines 1311 may be electrically connected with one first terminal 111 of the plurality of first terminals 111, so that different lines of the light emitting device-side conductive lines 1311 are electrically connected with different first terminals 111 of the plurality of first terminals 111 respectively. Optionally, each line of the light emitting device-side conductive lines 1311 may be electrically connected with at least two first terminals 111 of the plurality of first terminals 111, to provide a backup of electrical connection between the first terminals 111 and the light emitting device-side conductive lines 1311.

Referring to Fig. 2, in some embodiments, at least one terminal 110 of the plurality of terminals 110 may cover at least one terminal-side conductive hole 120 of the plurality of terminal-side conductive holes 120, for example, at least one terminal 110 of the plurality of terminals 110 may cover at least one terminal-side conductive hole 120, with which the terminal 110 is electrically connected, of the plurality of terminal-side conductive holes 120.

In some embodiments, at least one terminal 110 of the plurality of terminals 110 may cover part or all of at least one terminal-side conductive hole 120 of the plurality of terminal-side conductive holes 120, for example, at least one terminal 110 of the plurality of terminals 110 may cover part or all of at least one terminal-side conductive hole 120, with which the terminal 110 is electrically connected, of the plurality of terminal-side conductive holes 120. Optionally, at least one terminal 110 of the plurality of terminals 110 may not cover at least one terminal-side conductive hole 120, with which the terminal 110 is electrically connected, of the plurality of terminal-side conductive holes 120. Optionally, whether the terminal 110 covers the terminal-side conductive hole 120 or whether the terminal 110 covers part or all of the terminal-side conductive hole 120 is insignificant, as long as an electrical connection between the terminals 110 and the terminal-side conductive holes 120 may be effectively realized, to effectively arrange a plurality of terminals 110 for leading wires from the light emitting devices 150.

Referring to Fig. 1B, in some embodiments, part or all of terminals 110 of the plurality of terminals 110 may be arranged at equal intervals. Optionally, there may be a distance variation range between part or all of terminals 110 of the plurality of terminals 110, so that positions of part or all of terminals 110 of the plurality of terminals 110 may be flexibly set according to the distance variation range; for example, part of terminals 110 in the plurality of terminals 110 may be arranged at equal intervals while other terminals 110 may be set at unequal intervals, or all of terminals 110 in the plurality of terminals 110 may be set at unequal intervals.

Referring to Fig. 1B, in some embodiments, part of the plurality of terminals 110 may be arranged in array. Optionally, all of the plurality of terminals 110 may be arranged in array.

As shown in Fig. 1B, no matter whether part or all of the plurality of terminals 110 are arranged in array, an array arrangement mode of the plurality of terminals 110 may be a matrix, such as a row-and-column mode. In some embodiments, the array arrangement mode of the plurality of terminals 110 may be different from that shown in Fig. 1B, but may be array arrangement modes in other array shapes, such as circular, elliptical, triangular and other array arrangement modes. Optionally, the array arrangement mode of the plurality of terminals 110 is insignificant, as long as the plurality of terminals 110 for leading wires from the light emitting devices 150 may be effectively arranged.

In some embodiments, shapes of part or all of terminals 110 in the plurality of terminals 110 may be same or different. Optionally, since thicknesses of the terminals 110 are usually very small, the shapes of the terminals 110 may refer to shapes of surfaces of the terminals 110. Optionally, the shape of at least one terminal 110 of the plurality of terminals 110 may be rectangular, circular, spherical and other shapes; and other shapes such as polygonal and abnormal shapes may also be set according to actual conditions such as process requirements.

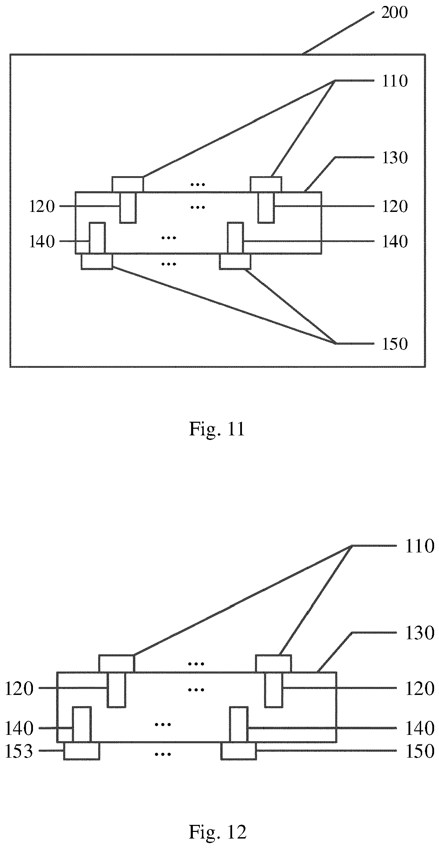

Referring to Fig. 11, embodiments of the present disclosure provide a display unit 200, including a plurality of light emitting devices 150, and the above mentioned terminal connection structure.

Referring to Fig. 12, in some embodiments, the plurality of light emitting devices 150 may include at least one Light Emitting Diode (LED) light emitting device 153, for example, part or all of the plurality of light emitting devices 150 may be LED light emitting devices 153.

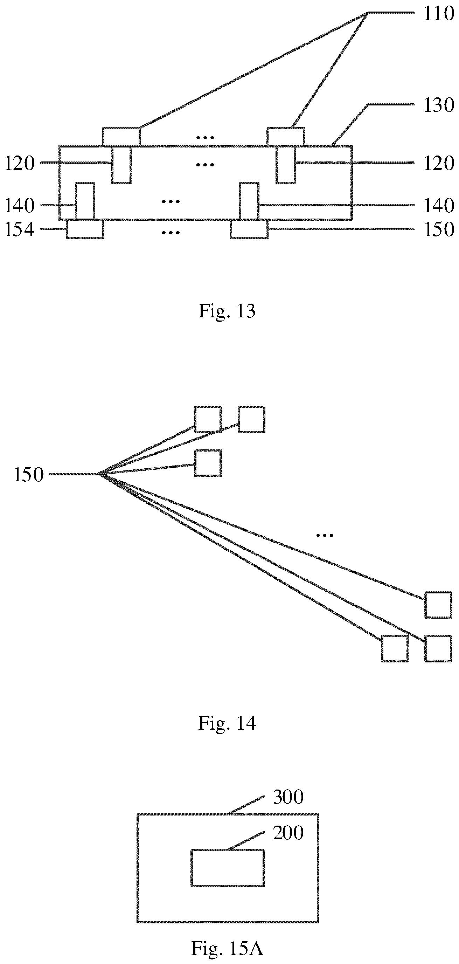

Referring to Fig. 13, in some embodiments, at least one LED light emitting device 153 may include at least one Micro LED light emitting device 154, for example, part or all of the plurality of light emitting devices 150 may be the Micro LED light emitting device 154. Optionally, at least one LED light emitting device 153 may include at least one Mini LED light emitting device; for example, part or all of the plurality of light emitting devices 150 may be the Mini LED light emitting device.

Referring to Fig. 14, in some embodiments, a plurality of light emitting devices 150 may be arranged in array.

In some embodiments, part of the plurality of light emitting devices 150 may be arranged in array. Optionally, all of the plurality of light emitting devices 150 may be arranged in array.

As shown in Fig. 14, no matter whether part or all of the plurality of light emitting devices 150 are arranged in array, an array arrangement mode of the plurality of light emitting devices 150 may be a matrix, such as a row-and-column mode. In some embodiments, the array arrangement mode of the plurality of light emitting devices 150 may be different from that shown in Fig. 14, but may be array arrangement modes in other array shapes, such as circular, elliptical, triangular and other array arrangement modes. Optionally, the array arrangement mode of the plurality of light emitting devices 150 is insignificant, as long as the plurality of terminals 110 for leading wires from the light emitting devices 150 may be effectively arranged.

In some embodiments, shapes of part or all of light emitting devices 150 in the plurality of light emitting devices 150 may be same or different. Optionally, since thicknesses of the light emitting devices 150 are usually very small, the shapes of the light emitting devices 150 may refer to shapes of longitudinal projections of the light emitting devices 150. Optionally, the shape of at least one light emitting device 150 of the plurality of light emitting devices 150 may be rectangular, circular, spherical and other shapes; and other shapes such as polygonal and abnormal shapes may also be set according to actual conditions such as process requirements.

In some embodiments, the display unit 200 may perform 3D display.

In some embodiments, different display units 200 may be spliced together. Optionally, a mode of splicing different display units 200 together and the number of spliced display units 200 may be considered according to actual conditions such as process requirements. Optionally, there is no lining frame between two spliced display units 200.

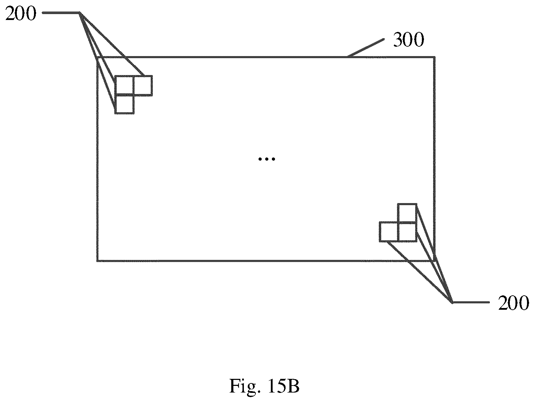

Referring to Figs. 15A and 15B, embodiments of the present disclosure provide a display 300, including the above mentioned display unit 200.

In some embodiments, the display 300 may perform 3D display.

In some embodiments, the display 300 may include at least one display unit 200; for example, the display 300 may include one, two, three or more display units 200. In the display 300 formed by the display units 200, there is no lining frame between two spliced display units 200.

As shown in Fig. 15B, part or all of the plurality of display units 200 arranged in the display 300 may be arranged in array. In some embodiments, an array arrangement mode of the plurality of display units 200 may be a matrix, such as a row-and-column mode. In some embodiments, the array arrangement mode of the plurality of display units 200 may be different from that shown in Fig. 15B, but may be arrangement modes in other array shapes, such as circular, elliptical, triangular and other array arrangement modes.

In some embodiments, different display units 200 arranged in the display 300 may be spliced together. Optionally, a mode of splicing different display units 200 together and the number of spliced display units 200 may be considered according to actual conditions such as process requirements. Optionally, there may be no lining frame between two spliced display units 200.

By the terminal connection structure, the display unit and the display provided by embodiments of the present disclosure, terminals for leading wires from light emitting devices may be arranged effectively even if a size of the light emitting device is very small.

The above description and drawings sufficiently illustrate the embodiments of the present disclosure to enable those skilled in the art to practice them. Other embodiments may include structural, logical, electrical, process, and other changes. The embodiments represent only possible changes. Unless expressly required, individual components and functions are optional and the order of operations may be changed. Parts and features of some embodiments may be included in or substituted for parts and features of other embodiments. The scope of the disclosed embodiments includes the full scope of the claims, and all available equivalents of the claims. When used in the present application, although the terms of "first", "second", etc. may be possibly used in the present application to describe various elements, these elements should not be limited by these terms. These terms are only used to distinguish one element from another. For example, without changing the meaning of the description, a first element may be called as a second element, and similarly, the second element may be called as the first element, as long as all of "the first elements" that appear are consistently renamed and all of "the second elements" that appear are consistently renamed. The first element and the second element are both elements, but may not be the same element. Moreover, the terms used in the present application are used to describe the embodiments only and not to limit the claims. As used in the illustration of the embodiments and the claims, unless clearly indicated in the context, the singular forms "a", "an" and "the" are also intended to include the plural forms. Similarly, the term "and/or" as used in the present application is meant to include any and all possible combinations of one or more of the associated listings. In addition, when used in the present application, the term "include" and its variations "includes" and/or "including", etc., refer to the presence of stated features, integers, steps, operations, elements, and/or components, but does not preclude the presence or addition of one or more other features, integers, steps, operations, elements, components and/or groupings of these. Without further limitations, an element limited by the phrase "comprises a..." does not preclude the presence of additional identical elements in the process, method or device that includes the element. Herein, the difference of each embodiment from each other may be the focus of explanation. The same and similar parts among all of the embodiments may be referred to each other. For the method and product disclosed by the embodiments, if the method and product correspond to a method part disclosed by the embodiments, the description of the method part may be referred to for the related part.

Those skilled in the art may recognize that the units and algorithm steps of each example described in conjunction with the embodiments disclosed herein may be implemented in electronic hardware, or a combination of computer software and electronic hardware. Whether these functions are performed in hardware or software may depend on the specific application and design constraints of the technical solution. Those skilled in the art may use different methods for implementing the described functions for each particular application, but such implementations should not be considered beyond the scope of the embodiments of the present disclosure. Those skilled in the art may clearly understand that, for the convenience and brevity of description, the corresponding processes in the above method embodiments may be referred to for the specific working processes of the above systems, devices and units, which will not be repeated here.

In the embodiments disclosed herein, the disclosed method and product (including, but not limited to the apparatus and the device) may be realized in other ways. For example, the device embodiments described above are merely schematic. For example, the division of the units may be only a logical functional division, and may be an additional division manner in actual realization. For example, multiple units or components may be combined or integrated into another system, or some features may be ignored or not executed. In addition, the displayed or discussed mutual coupling or direct coupling or communication connection may be indirect coupling or communication connection through some interfaces, devices or units, and may be electrical, mechanical or other forms. The units described as separate components may or may not be physically separated, and the components shown as the units may or may not be physical units, that is, may be located in one place, or may be distributed on multiple network units. The present embodiments may be implemented by selecting some or all of the units according to actual needs. In addition, each functional unit in the embodiments of the present disclosure may be integrated into one processing unit, or each unit may exist physically alone, or two or more units may be integrated into one unit.

## Claims

1. A terminal connection structure, comprising: a plurality of terminals, a plurality of terminal-side conductive holes, an electrical connection layer, and a plurality of light emitting device-side conductive holes, wherein
the electrical connection layer is capable of being electrically connected with a plurality of light emitting devices through the plurality of light emitting device-side conductive holes, and electrically connected with the plurality of terminals through the plurality of terminal-side conductive holes;
the plurality of terminals are arranged in array.

2. The terminal connection structure according to claim 1, wherein the electrical connection layer comprises at least two electrical connection layers; and the at least two electrical connection layers are capable of being electrically connected with a plurality of light emitting devices through the plurality of light emitting device-side conductive holes, and electrically connected with the plurality of terminals through the plurality of terminal-side conductive holes.

3. The terminal connection structure according to claim 2, wherein the at least two electrical connection layers comprise a light emitting device-side electrical connection layer and a terminal-side electrical connection layer; the plurality of light emitting device-side conductive holes comprise a plurality of first light emitting device conductive holes and second light emitting device conductive holes;
wherein the light emitting device-side electrical connection layer is capable of being electrically connected with the plurality of light emitting devices through the plurality of first light emitting device conductive holes;
the terminal-side electrical connection layer is capable of being electrically connected with the plurality of light emitting devices through the plurality of second light emitting device conductive holes.

4. The terminal connection structure according to claim 3, wherein at least one of the plurality of light emitting devices comprises a first electrode and a second electrode;
wherein the light emitting device-side electrical connection layer is capable of being electrically connected with the first electrode through at least one of the plurality of first light emitting device conductive holes;
the terminal-side electrical connection layer is capable of being electrically connected with the second electrode through at least one of the plurality of second light emitting device conductive holes.

5. The terminal connection structure according to claim 4, wherein each light emitting device of the plurality of light emitting devices comprises a first electrode and a second electrode;
wherein the light emitting device-side electrical connection layer is capable of being electrically connected with first electrodes of different light emitting devices in the plurality of light emitting devices through the plurality of first light emitting device conductive holes respectively;
the terminal-side electrical connection layer is capable of being electrically connected with second electrodes of different light emitting devices in the plurality of light emitting devices through the plurality of second light emitting device conductive holes respectively.

6. The terminal connection structure according to claim 3, wherein the terminal-side electrical connection layer and the light emitting device-side electrical connection layer are sequentially arranged from the plurality of terminals to the plurality of light emitting devices.

7. The terminal connection structure according to claim 6, further comprising at least one of following insulation layers:
an insulation layer for isolating the plurality of terminals from the terminal-side electrical connection layer;
an insulation layer for isolating the terminal-side electrical connection layer from the light emitting device-side electrical connection layer;
an insulation layer for isolating the light emitting device-side electrical connection layer from the plurality of light emitting devices.

8. The terminal connection structure according to any one of claims 3 to 7, wherein the plurality of terminal-side conductive holes comprise a plurality of first terminal conductive holes and a plurality of second terminal conductive holes;
wherein the light emitting device-side electrical connection layer is electrically connected with the plurality of terminals through the plurality of first terminal conductive holes;
the terminal-side electrical connection layer is electrically connected with the plurality of terminals through the plurality of second terminal conductive holes.

9. The terminal connection structure according to claim 8, wherein the plurality of terminals comprise at least one first terminal and at least one second terminal;
wherein the light emitting device-side electrical connection layer is electrically connected with the at least one first terminal through at least one of the plurality of first terminal conductive holes;
the terminal-side electrical connection layer is electrically connected with the at least one second terminal through at least one of the plurality of second terminal conductive holes.

10. The terminal connection structure according to claim 9, wherein the at least one first terminal comprises a plurality of first terminals, and the at least one second terminal comprises a plurality of second terminals;
wherein the light emitting device-side electrical connection layer is electrically connected with the plurality of first terminals through the plurality of first terminal conductive holes respectively;
the terminal-side electrical connection layer is electrically connected with the plurality of second terminals through the plurality of second terminal conductive holes respectively.

11. The terminal connection structure according to any one of claims 3 to 10, wherein at least one of the light emitting device-side electrical connection layer and the terminal-side electrical connection layer is arranged in following modes:
the light emitting device-side electrical connection layer comprises at least one layer of light emitting device-side conductive lines;
the terminal-side electrical connection layer comprises at least one layer of terminal-side conductive lines.

12. The terminal connection structure according to claim 11, wherein at least one of the light emitting device-side conductive lines and the terminal-side conductive lines is arranged in array.

13. The terminal connection structure according to claim 12, wherein at least one of the light emitting device-side conductive lines and the terminal-side conductive lines is arranged in array in a form of rows or columns.

14. The terminal connection structure according to claim 13, wherein
the light emitting device-side conductive lines are arranged in array in a form of rows, and the terminal-side conductive lines are arranged in array in a form of columns; or,
the light emitting device-side conductive lines are arranged in array in a form of columns, and the terminal-side conductive lines are arranged in array in a form of rows.

15. The terminal connection structure according to claim 11, wherein
each line of the terminal-side conductive lines is electrically connected with at least one terminal of the plurality of terminals, or
each line of the light emitting device-side conductive lines is electrically connected with at least one terminal of the plurality of terminals.

16. The terminal connection structure according to claim 1, wherein at least one terminal of the plurality of terminals covers at least one terminal-side conductive hole of the plurality of terminal-side conductive holes.

17. The terminal connection structure according to claim 1, wherein part or all terminals of the plurality of terminals are arranged at equal intervals.

18. The terminal connection structure according to claim 1, wherein
part of the plurality of terminals are arranged in array; or,
all of the plurality of terminals are arranged in array.

19. A display unit, comprising a plurality of light emitting devices and the terminal connection structure of any one of claims 1 to 18.

20. The display unit according to claim 19, wherein the plurality of light emitting devices comprise at least one light emitting diode (LED) light emitting device.

21. The display unit according to claim 20, wherein the at least one LED light emitting device comprises at least one Micro LED light emitting device.

22. The display unit according to any one of claims 19 to 21, wherein the plurality of light emitting devices are arranged in array.

23. The display unit according to claim 22, wherein
part of the plurality of light emitting devices are arranged in array; or,
all of the plurality of light emitting devices are arranged in array.

24. A display, comprising the display unit of any one of claims 19 to 23.
